(19) Europäisches Patentamt
European Patent Office
Office européen des brevets

(11) **EP 1 947 221 A2**

(12) **EUROPEAN PATENT APPLICATION**

(43) Date of publication:
**23.07.2008 Bulletin 2008/30**

(51) Int Cl.:
*C30B 29/06* [(2006.01)]   *C30B 11/00* [(2006.01)]
*B22D 23/06* [(2006.01)]

(21) Application number: **08000576.2**

(22) Date of filing: **14.01.2008**

(84) Designated Contracting States:
**AT BE BG CH CY CZ DE DK EE ES FI FR GB GR HR HU IE IS IT LI LT LU LV MC MT NL NO PL PT RO SE SI SK TR**
Designated Extension States:
**AL BA MK RS**

(30) Priority: **16.01.2007 JP 2007006762**

(71) Applicant: **Sumco Solar Corporation**
**Kainan-shi**
**Wakayama 642-0001 (JP)**

(72) Inventors:
• **Sasatani, Kenichi**
  **Kainan-shi**
  **Wakayama 642-0001 (JP)**
• **Nakagawa, Keita**
  **Kainan-shi**
  **Wakayama 642-0001 (JP)**
• **Onizuka, Tomohiro**
  **Kainan-shi**
  **Wakayama 642-0001 (JP)**
• **Kubo, Nobuyuki**
  **Kainan-shi**
  **Wakayama 642-0001 (JP)**

(74) Representative: **Albrecht, Thomas et al**
**Kraus & Weisert**
**Patent- und Rechtsanwälte**
**Thomas-Wimmer-Ring 15**
**80539 München (DE)**

(54) **Casting method for polycrystalline silicon**

(57) In a casting method for polycrystalline silicon in which a bottomless cooling crucible with a part of a certain length in an axial direction being circumferentially and plurally sectioned is provided inside an induction coil, producing a silicon melt within the cooling crucible by means of electromagnetically induced heating by the induction coil, and withdrawing the silicon melt in a downward direction while being solidified, an alternating current with a frequency of 25 - 35 kHz is applied on the induction coil. According to the casting method for polycrystalline silicon of the present invention, in addition to preventing rapid cooling of the ingot surface at the time of solidifying the molten silicon and producing the ingot, the stirring of the molten silicon inside the crucible is suppressed to thereby promote the growth of large diameter crystals, with the result that the conversion efficiency of the cast polycrystalline silicon used as solar cells is increased.

EP 1 947 221 A2

**Description**

BACKGROUND OF THE INVENTION

1. Field of the Invention

The present invention relates to a continuous casting method for polycrystalline silicon by electromagnetic induction. More particularly, it relates to a casting method for polycrystalline silicon in which, at the time of solidifying the molten silicon and producing the ingot, a rapid cooling of the ingot surface is moderated, while allowing the stirring of molten silicon in a crucible to be suppressed to promote the growth of a crystal with a large diameter, thereby enabling to increase a conversion efficiency when used as a solar cell.

2. Description of the Related Art

Silicon crystals are being used as substrate materials for the majority of solar cells presently produced. Silicon crystals are classified as single crystals and polycrystals, but generally speaking, the use of single crystals as substrates proves to be superior in obtaining solar cells with high conversion efficiency when converting incident light energy into electric energy.

Single crystal silicon requires a high quality dislocation free crystal and is therefore produced by the Czochralski method whereby the single crystal is pulled up and grown from molten silicon. However, single crystal silicon grown with the Czochralski method has the disadvantage of incurring higher production costs when compared with polycrystalline silicon discussed hereafter. Consequently, the use of single crystal silicon as substrates for solar cells causes the problem of increasing production costs for solar cells.

On the other hand, polycrystalline silicon is generally produced by a casting method whereby molten silicon is solidified in a mold (hereafter "casting method") or by a continuous casting method using electromagnetic induction (hereafter "electromagnetic casting method"), offering the possibility of producing substrate materials at lower costs than the single crystal silicon substrate produced by the Czochralski method.

With the casting of polycrystalline silicon according to the casting method, a high-purity silicon serving as a raw material is heated and melted in a crucible, and after uniformly adding a trace amount of boron or the like as a doping agent, the molten silicon is solidified inside the crucible and poured into a mold to be solidified. As the crucible and mold employed in the casting method are required to have a superior heat-resistance and shape durability and to contain impurities as low as possible, quartz is used for the crucible and graphite for the mold.

By applying a unidirectional solidification method in this casting method, it becomes possible to obtain polycrystalline silicon with large crystal grains, but as the casting method is an ingot casting method whereby the molten silicon is solidified with the mold, various problems arise. For example, contamination by impurities occurs upon the molten silicon and the mold wall coming into contact, or a mold releasing agent used to prevent adhesion of the ingot to the mold is mixed into the molten silicon.

As stated above, the fact that high-purity materials such as quartz crucibles and graphite molds are used in the casting method in addition to the need for these to be replaced periodically, leads to a rise in production costs. Moreover, the casting method is an ingot casting method, and difficulties with continuous casting result in a decrease in the production efficiency.

As a method for solving these problems, an electromagnetic casting method has been developed to make it possible to cast silicon crystals with least contact between the molten silicon and the crucible or mold.

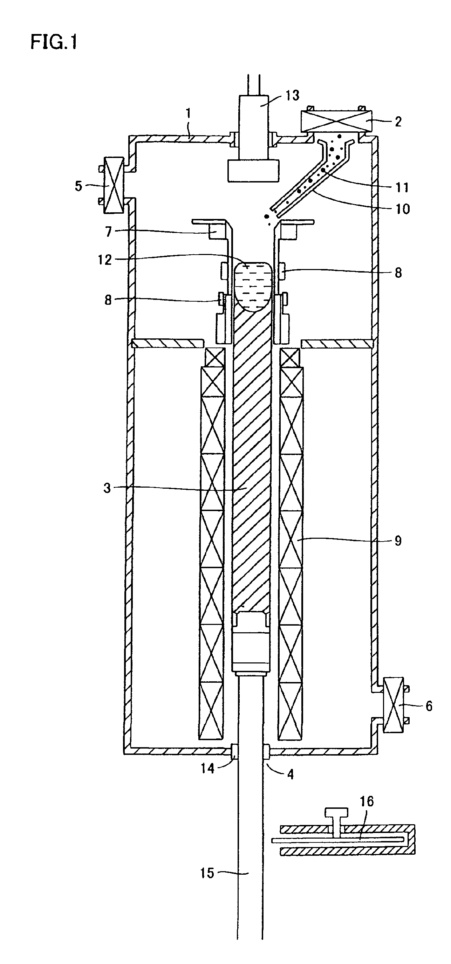

Fig. 1 illustrates schematically an example of an electromagnetic casting furnace used in an electromagnetic casting method. A chamber 1, consisting of a water cooled container of double-walled structure so as to be protected from the generated heat of the inside, is at its upper part connected to a raw material supplying device partitioned off by a shielding device 2 and has at the bottom part a withdrawal port 4 for the withdrawal of an ingot 3. The chamber 1 is provided with an inert gas inlet 5 at the side wall of the upper part and a vacuum suction port 6 at the side wall of the bottom part.

In the central part of the chamber 1, as means for the electromagnetic casting, there are provided a cooling crucible 7, an induction coil 8 and an after heater 9. The cooling crucible 7, consisting of a watercooled square cylindrical body of copper make, is a bottomless crucible which is circumferentially and plurally sectioned, i.e., a comb-like configuration, leaving the upper part as being not sectioned. The induction coil 8 is concentrically and circumferentially provided onto the outer side of the cooling crucible 7, being connected to a power supply by means of a coaxial cable not shown in the figure. The after heater 9, being concentrically connected to the lower part of the cooling crucible 7, heats the ingot 3 which is pulled down from the cooling crucible 7 and provides a prescribed temperature gradient in its axial direction.

A raw material supply conduit 10 is provided in a downward direction underneath a shielding device 2 disposed in chamber 1, so as to allow a granular, and/or a lump-like silicon raw material 11 fed into the raw material supply conduit 10, to be supplied to the molten silicon 12 inside the cooling crucible 7. An auxiliary heater 13 composed of graphite and the like is provided with ascending and descending capability just above the cooling crucible 7 so as to be inserted in the cooling crucible 7 when in the descending mode.

Underneath the after-heater 9, a gas seal part 14 is provided in addition to a withdrawing device 15 which withdraws the ingot 3 in a downward direction while supporting it. Underneath the gas seal part 14, at the outside of the chamber 1, a diamond cutting-off machine 16 is provided as a mechanical cutting-off device. The diamond cutting-off machine 16 is capable of descending synchronously with the withdrawing speed of the ingot 3 and cuts off the ingot 3 withdrawn from the chamber 1 through the withdrawal port 4 while moving synchronously.

According to an electromagnetic casting method using the aforementioned electromagnetic casting furnace, the silicon raw material 11 is fed into the cooling crucible 7 constructed as a melting vessel whereby, upon the alternating current passing through the induction coil 8, and as strip-like elements constituting the cooling crucible 7 are electrically isolated from each other, the electrical current forms a loop within the individual element, whereby the electrical current in the inner wall side of the cooling crucible 7 creates a magnetic field within the cooling crucible 7, thus making it possible to heat and melt the silicon raw material 11.

The silicon raw material 11 in the cooling crucible 7 is melted without coming into contact with the cooling crucible 7 due to the fact that it inwardly receives force (pinch force) in a direction normal to a side surface of the molten silicon 12 as a result of the interaction between the electrical current on the molten silicon 12 surface and the magnetic field created by the electrical current on the inner wall of the cooling crucible 7. As a result, the withdrawing of the ingot 3 becomes easy, and moreover, contamination of the ingot 3 through contact with the cooling crucible 7 is prevented.

According to this electromagnetic casting method, the cooling crucible used for melting is also used for solidifying. More specifically, when the withdrawing device 15 holding the ingot 3 and the molten silicon 12 at the lower part is made to move downward while melting the silicon raw material 11 in the cooling crucible 7, the farther they move away from the lower end of the induction coil 8, the smaller the induction magnetic field becomes, thereby resulting in reduction of both heat value and pinch force, whereby moreover due to the cooling from the cooling crucible 7, the solidification progresses from the outer peripheral portion of the molten silicon 12. By successively feeding the silicon raw material 11 from the upper part of the cooling crucible 7 and continuing the melting and solidification in coordination with the downward movement of the withdrawing device 15, it is possible to continuously cast silicon polycrystals while solidifying from the lower part of the crucible, without the silicon melt coming into contact with the crucible wall.

As stated above, the electromagnetic casting method offers the advantage of the molten silicon having least contact with the crucible, the advantage of the absence of the need of using of a high-purity material for the crucible, and the advantage of the possibility of accelerating the casting speed by virtue of a large cooling surface. These advantages, heretofore, have inspired a variety of research aimed at improving the quality of solar cells using polycrystalline silicon as a substrate.

For example, JP S 63/192543 proposes an electromagnetic induction casting device wherein the upper part of a conductive bottomless crucible constitutes a water cooling zone and the lower part constitutes a non-cooling zone in addition, to which at least one part of a certain length in a lengthwise direction straddling both the water cooling zone and the non-cooling zone is circumferentially and plurally divided by longitudinal slits. This type of device ensures sufficient cooling capacity for initiating the solidification of the molten silicon at the upper part of the bottomless crucible and also is possible to circumvent a rapid cooling to occur in the lower part of the bottomless crucible in case of water cooling, thereby making it possible to prevent an increase in the temperature gradient caused by temperature change.

In this way, the mitigation of rapid cooling at a time of solidifying the molten silicon and producing the ingot is important for improving performance of solar cells and for this reason, various technical developments has been seen heretofore.

SUMMARY OF THE INVENTION

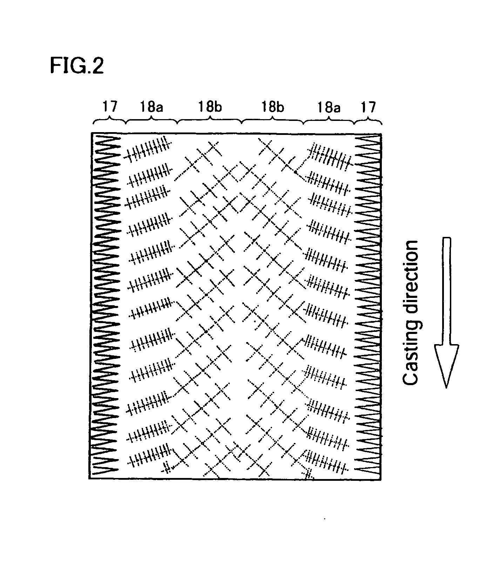

Fig. 2 illustrates schematically a crystal pattern of a longitudinal section of an ingot which was cast in an electromagnetic casting method. As for the crystal pattern of the longitudinal section of the ingot, from the surface of the ingot, a chill layer 17 with crystals of small diameter grows in a direction normal to the surface part, whereas the more the site of the columnar crystals 18a, 18b approaches toward the center portion, the more they grow and get enlarged in the direction of the heat source in the upper part.

In the inner part of the ingot, semiconductor properties are excellent as a result of the existence of the columnar crystals 18a, 18b which have grown a large crystal diameter, whereas in chill layer 17, semiconductor properties cannot be excellent as a result of the small crystal diameter and plenty of crystalline defects. For this reason, in order to improve the conversion efficiency of cast polycrystalline silicon used as solar cells, the need arises to suppress the growth of chill layer 17. As this chill layer 17 occurs on the ingot surface with its high solidification speed, the growth of chill layer 17 can be suppressed by mitigating the rapid cooling of the ingot surface at the time of solidifying the molten silicon and producing the ingot, that is, by maintaining the surface temperature at high temperatures in order to delay the initiation of solidification caused by cooling from the ingot surface.

As a means of maintaining the surface temperature of the ingot at high temperatures, raising the temperature of the total mass of molten silicon by increasing the calorific value of the molten silicon is worth considering. Hereby, the calorific value of the molten silicon is determined by the strength of the magnetic field created by the induction coil and the strength of this magnetic field is determined by the current value of the alternating current applied on the induction coil. In other words, the temperature of the total mass of molten silicon rises by raising the current value of the alternating current applied on the induction coil whereby consequently the surface temperature of the ingot is maintained at a high temperature. To this end, with conventional electromagnetic casting methods, for example, an alternating electric current with high current value of 6000A is applied on the induction coil for an ingot with a square cross section of 350mm in side length.

On the other hand, according to an electromagnetic casting method, when the alternating current is applied on the induction coil, electric current is generated in the crucible sectioned strips whereby the current produced in the sectioned strips produces the current J in the molten silicon. Consequently, the current J occurring in the molten silicon is proportionate to the current value I of the alternating current applied on the induction coil. Moreover, the strength B of the magnetic field is proportionate to the current value I of the alternating current applied on the induction coil. The electromagnetic force F acting on the molten silicon is expressed as the product of the current J flowing in the molten silicon and the strength B of the magnetic field and consequently given as the equation hereunder (1).

$$F = J \times B = (\alpha_1 \times I) \times (\alpha_2 \times I) = \alpha \times I^2 \ \ldots (1)$$

where $\alpha$, $\alpha_1$ and $\alpha_2$ are coefficients.

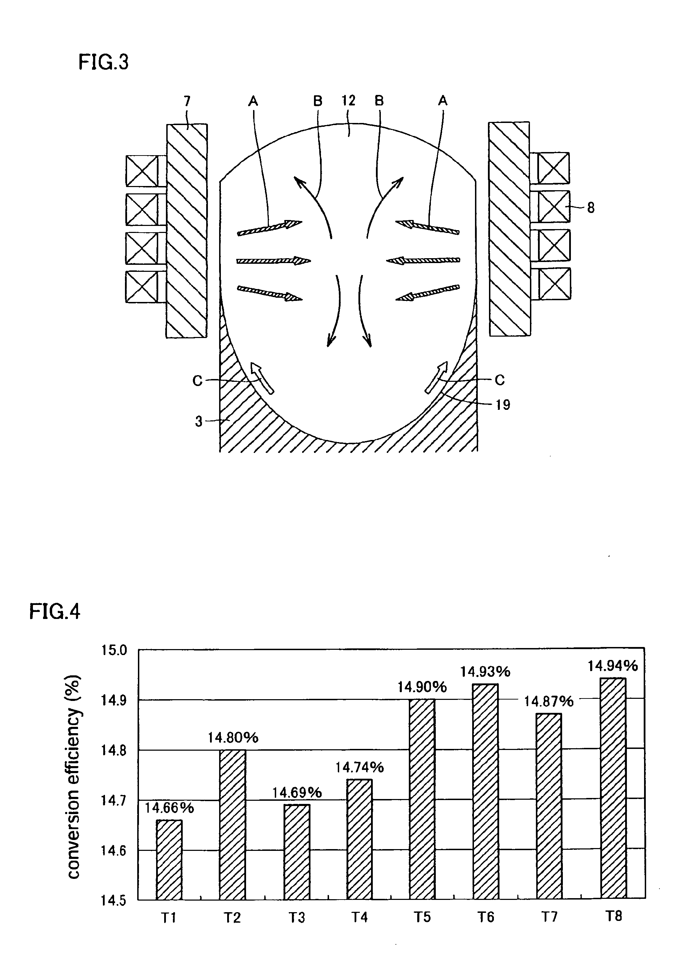

Fig. 3 schematically illustrates the stirring condition of the molten silicon at the time of casting a silicon ingot using an electromagnetic casting method. The molten silicon 12 is held in a state loaded on top of the ingot 3 inside of the cooling crucible 7 provided within the induction coil 8. The electromagnetic force, as shown in the aforementioned equation (1), being proportionate to the second power of the current value of the alternating current applied on the induction coil, operates as the pinch force squeezing the molten silicon inside the cooling crucible toward the inside (direction of the diagonal arrows A in the figure). As a result of the squeezing effect of the pinch force, a stirring force (hereunder termed 'electromagnetic stirring force') occurs in the direction of the solid arrows B in the figure.

The electromagnetic stirring force being proportionate to the strength of the pinch force, that is, the electromagnetic force becomes proportionately stronger to the second power of the current value of the alternating current applied on the induction coil when that current value increases. When this electromagnetic stirring force increases, the molten silicon 12 flows along the solid-liquid interface 19 between the ingot 3 and the molten silicon 12 (direction of the outline arrows C in the figure) whereby the unidirectional solidification does not stabilize and the growth of crystals with a large diameter is hindered. As a result, disorder occurs among the crystal grains of the inner part of the cast ingot 3, the crystal grain diameter grows smaller and there arises the problem in decrease of the conversion efficiency as solar cells.

When the electromagnetic stirring force becomes further larger and the molten silicon 12 is stirred more intensively, the skin surface of the solidified silicon ruptures, and there occurs a phenomenon such that part of the molten silicon 12 exudes, simultaneously cools off rapidly and solidifies (hereunder termed 'melt drip'), and fine concavo-convex irregularities are formed on the casting surface of the ingot 3. When such melt drip occurs, the casting surface of the ingot 3 suffers damage and the number of crystal defects on the surface part increases, thereby leading to a decrease in the conversion efficiency as solar cells.

Moreover, when the electromagnetic stirring force acts on the melt surface of the molten silicon 12, the casting of the ingot 3 is performed with the upper part of the molten silicon 12 being protruded as shown in Fig. 3. Generally, according to the electromagnetic casting method, the narrower the gap between the molten silicon 12 and the inner wall of cooling crucible 7, the more stable the flow of the electric current to the surface of the molten silicon 12, resulting in the possibility of performing the electromagnetic casting with superior electric power efficiency. However, in a situation where the upper part of the molten silicon 12 is protruding as a result of the electromagnetic stirring force, the gap between the molten silicon 12 and the inner wall of the cooling crucible 7 widens, whereby the electric power efficiency in the electromagnetic casting decreases.

As stated above, applying on the induction coil an alternating current with high current value is effective in obtaining a higher temperature for the ingot surface temperature and suppressing the growth of the chill layer; however, on the other hand, it increases the electromagnetic stirring force acting on the molten silicon, and not only it hinders the growth of the large diameter crystals inside the ingot, but also it causes the melt drip and a decrease in the electric power efficiency

The present invention is made in view of the problems mentioned above, and its object is to provide a casting method for polycrystalline silicon wherein at the time of solidifying the molten silicon and producing the ingot, the rapid cooling of the ingot surface is mitigated, while allowing the stirring of the molten silicon inside the crucible to be suppressed to promote the growth of large diameter crystals, thereby enabling to obtain solar cells with high conversion efficiency.

The inventors of the present invention have carried out a variety of investigations concerning an electromagnetic casting method that mitigates the rapid cooling of the ingot surface, while making it possible to suppress the stirring of the molten silicon inside the crucible at the time of solidifying the molten silicon and producing the ingot. As a result, they observed that by increasing the frequency of the alternating electric current applied on the induction coil, a skin effect is produced on the molten silicon, the current is concentrated on its surface, and the current density at the molten silicon surface is increased, whereby it becomes possible to maintain the surface temperature of the ingot at high temperature and the initiation of solidification caused by cooling from its surface is delayed.

Furthermore, by increasing the frequency of the alternating current applied on the induction coil, it is possible to increase the current density caused by the skin effect on the molten silicon and lower the coil current value. It is learned that as a result of the electromagnetic stirring force acting on the molten silicon being proportionate to the second power of the current value, it is possible, by raising the frequency and lowering the coil current value, to suppress the stirring of the molten silicon while maintaining melting capacity thereby making it possible to cast silicon poly-crystals by means of stable unidirectional solidification.

Moreover, as a result of the possibility to suppress the stirring of the molten silicon, it becomes possible to stabilize the configuration of the molten silicon, thereby making it possible to perform electromagnetic casting with high current efficiency.

The present invention is completed on the basis of the findings mentioned above, where the gist thereof pertains to the casting method for polycrystalline silicon described in (1) - (3) hereunder.

(1) A casting method for polycrystalline silicon, characterized in that a bottomless cooling crucible with a part of certain length in an axial direction being sectioned circumferentially and plurally is provided inside an induction coil, thereby forming a silicon melt within the cooling crucible by means of electromagnetically induced heating by the induction coil, and furthermore the silicon melt is withdrawn in the downward direction while being solidified and furthermore an alternating electric current with a frequency of 25-35 kHz is applied on the induction coil.

(2) According to the casting method for polycrystalline silicon contained in (1) stated above, the cross-section shape of a cast silicon ingot is preferably a square of 300-450 mm in side length.

(3) According to the casting method for polycrystalline silicon contained in (1) and (2) stated above, it is preferable that the cast polycrystalline silicon is used for solar cell substrates because it can increase the conversion efficiency of solar cells.

According to the casting method of the present invention, as a result of casting polycrystalline silicon with a high frequency range of 25-35 kHz as the frequency of the alternating current applied on the induction coil, it is possible to lower the current value of the alternating current, thereby making it possible, as a result of the skin effect caused by the high frequency, to maintain the surface temperature at high temperature when solidifying the molten silicon and producing the ingot, whereby it becomes possible to delay initiation of the solidification from the ingot surface. As a result, it is possible to relatively suppress the growth of the chill layer.

Moreover, by lowering the current value of the alternating current applied on the induction coil, it is possible to reduce the electromagnetic stirring force acting on the molten silicon whereby, as a result of being able to suppress the stirring of the molten silicon, it is possible to promote the growth of large diameter crystals in the inner part of the ingot. Moreover, by suppressing the stirring of the molten silicon, it is possible to prevent the occurrence of melt drip, thereby making it possible to suppress the deterioration of semiconductor properties on the ingot surface and moreover to stabilize the configuration of the molten silicon, whereby it becomes possible to perform electromagnetic casting with high current efficiency.

In this way, according to the casting method for polycrystalline silicon of the present invention, it is possible to suppress the deterioration of semiconductor properties of the inner part and surface of the ingot, with the result that it becomes possible to increase the conversion efficiency as solar cells.

BRIEF DESCRIPTION OF THE DRAWINGS

Fig. 1 schematically illustrates an example of an electromagnetic casting furnace used in an electromagnetic casting method.
Fig. 2 schematically illustrates a crystal pattern of a longitudinal cross section of an ingot cast with an electromagnetic casting method.

Fig. 3 schematically explains the state of stirring of the molten silicon at the time of casting a silicon ingot with an electromagnetic casting method.

Fig. 4 shows the weighted average value of the conversion efficiency as solar cells in embodiments.

## DETAILED DESCRIPTION OF THE PREFERRED EMBODIMENTS

The casting method of the present invention is characterized in that it sets the frequency of the alternating current applied on the induction coil at 25-35 kHz. In contrast to the conventional electromagnetic casting methods with the frequency of the alternating current at around 10 kHz, the use of an alternating current with a high frequency of 25-35 kHz has its reason in the fact that it thereby is possible to generate a skin effect on the molten silicon constituting the current carrying body and to increase the current density on the surface of the molten silicon.

A skin depth d caused by the skin effect in a conductor with magnetic permeability $\mu$ and conductivity o, is given in the equation (2) hereunder,

$$d = 1 / ( \pi \times f \times \mu \times \sigma )^{1/2} \quad ... (2)$$

f is here the frequency of the alternating current flowing in the conductor.

As shown in the equation (2) above, the skin depth caused by the skin effect is determined by the frequency of the alternating current and the conductivity of the molten silicon. Consequently, with the conductivity of the molten silicon being constant, the higher the frequency of the alternating current is, the shallower the skin depth becomes, with the result that the current density on the molten silicon surface rises. In other words, as the casting method of the present invention provides a possibility to increase the current density on the surface of the molten silicon to the extent that the frequency of the alternating current applied on the induction coil is made to rise, the surface temperature can be maintained at high temperature at the time of solidifying the molten silicon and producing the ingot, and initiation of the solidification caused by cooling from the ingot surface can be delayed. As a result, the growth of the chill layer can be relatively suppressed.

However, as the current concentrates itself excessively on the surface part of the molten silicon when the frequency exceeds 35 kHz, electric discharges occur between the molten silicon and the inner wall of the cooling crucible, with the risk of damage to the cooling crucible. The upper limit of the frequency of the alternating current applied on the induction coil is therefore set at 35 kHz. An even more preferable upper limit would be 32 kHz.

As stated above, according to the casting method of the present invention, the current value of the alternating current can be lowered by increasing the frequency of the alternating current applied on the induction coil; furthermore, as a result of the skin effect caused by the high frequency, at the time of solidifying the molten silicon and producing the ingot, it is possible to maintain the surface temperature at high temperature and to delay the initiation of solidification caused by cooling from the ingot surface. Moreover, by lowering the current value of the alternating current applied on the induction coil, it is possible to reduce the electromagnetic stirring force acting on the molten silicon.

Because of the electromagnetic stirring force being proportionate to the electromagnetic force acting on the molten silicon and also the electromagnetic force being proportionate to the second power of the current value, it follows that if, for example, the current value is reduced by a factor of 1/2, the electromagnetic stirring force is reduced by a factor of 1/4. In this way, the casting method of the present invention is capable of substantially reducing the electromagnetic stirring force and therefore capable of suppressing the stirring of the molten silicon in addition to securely preventing the occurrence of melt drip in association with the stirring.

As a result, it becomes possible to promote the growth of large diameter crystals and cast silicon polycrystals while securely proceeding with unidirectional solidification. However, as these outstanding results are not obtained with a frequency under 25 kHz, the lower limit of the frequency of the alternating current is set at 25 kHz.

Moreover, the casting method of the present invention is characterized in that the shape of the cross section of the cast silicon ingot is a square of 300-450 mm in side length. According to the casting method of the present invention, as a result of applying an alternating current with high frequency on the induction coil, it becomes possible to increase the current density on the molten silicon surface and therefore to lower the current value of the alternating current. That is, according to the casting method of the present invention, by applying an alternating current with high frequency on the induction coil it becomes possible to cast polycrystalline silicon with a high voltage and moreover a low current. Therefore, according to the casting method of the present invention, even when the need arises to increase power, it is possible to provide the necessary power by increasing the voltage while simultaneously suppressing the increase of the electromagnetic stirring force by keeping the current low.

On the other hand, the power needed to melt and solidify the silicon raw material fed into the cooling crucible is proportionate to the length of the side of the ingot which is planned to be cast. In other words, as also the power needed for melting and solidifying the silicon raw material in the crucible increases when the side length of the cast ingot section becomes larger, it is necessary to increase the voltage applied on the induction coil. However, when the applied voltage increases beyond the limit, a discharge occurs between the molten silicon and the inner wall of the cooling crucible with the risk of damaging the cooling crucible, therefore the upper limit for the side length of a square cross section of the cast ingot has been set at 450 mm.

Moreover, since also the power needed for melting and solidifying the silicon raw material inside the crucible decreases when a side length of the cast ingot section is smaller, it becomes possible to perform the casting with a low voltage and moreover a low current. That is, as the danger of a discharge between the molten silicon and the inner wall of the cooling crucible is minimal when the side length of the cast ingot section is small, it also becomes possible to increase the frequency of the alternating current applied on the induction coil beyond 35 kHz.

In this way, according to the casting method of the present invention, it is possible to further increase the frequency of the alternating current applied on the induction coil by shortening on a side length of the cast ingot section while simultaneously further decreasing the current value of the alternating current making it possible to suppress the stirring of the molten silicon and thereby aim at improving the quality of polycrystalline silicon. However, according to the casting method of the present invention, the production efficiency decreases as a result of the reduction in weight per unit length of the ingot if the side length of the ingot section is shortened.

To this end, according to the casting method of the present invention, we have taken 300 mm as the lower limit of a side length of a square cross section of a cast ingot in order to secure improvement of the quality of polycrystalline silicon and also the production efficiency comparable with the conventional casting methods.

As stated above, the side length of a square cross section of the ingot is limited to 450 mm or less to prevent the occurrence of discharges in association with an increase of the circumferential length of the ingot. Moreover, the skin effect occurs irrespective of the shape of the cross section of the cast silicon ingot. Therefore, the casting method of the present invention is also applicable to a cast silicon ingot with a rectangular cross section with a total circumferential length being equal to or less than that of a square cross section of 450 mm in side length. A relevant example is a silicon ingot having a rectangular cross section with a major side length of 500 mm and a minor side length of 350 mm.

EXAMPLES

To ascertain the effects of the present invention, we have cast polycrystalline silicon and evaluated its conversion efficiency as a solar cell.

Using an electromagnetic casting furnace shown in the aforementioned Fig. 1, a silicon ingot intended as a source material for a solar cell substrate was cast with a square cross section of 350 mm in side length.

The comparative examples, Test Nos. T1- T4, were at the time of casting given a current value of 6000 A and a frequency of 12 kHz for the alternating current applied on the induction coil. Moreover, Test No. T5, an inventive example of the present invention, was given a current value of 4500 A and a frequency of 25 kHz for the alternating current applied on the induction coil, while Test Nos. T6 - T8, inventive examples, were given a current value of 4000 A and a frequency of 30 kHz for the alternating current at the time of casting. Apart from the current value and the frequency of the applied alternating current, both comparative examples and inventive examples of the present invention were subjected to the same experiment conditions.

The obtained silicon ingot was cut off into substrates with a thickness of 220 $\mu$m, and solar cells were produced from these substrates. The conversion efficiency as solar cells was measured for 100000 pieces or more of solar cells per each example in all Test Nos. T1 - T8. Based on measurement results, the percentage distribution of the conversion efficiency as solar cells is shown in Table 1.

Table 1

| Section | Test No. | Frequency (kHz) | Current Value (A) | Substrate Thickness (μm) | Percentage Distribution of Conversion Efficiency (%) | | | | |
|---|---|---|---|---|---|---|---|---|---|
| | | | | | 13.0%≦ <13.5% | 13.5%≦<14.0% | 14.0%≦<14.5% | 14.5%≦<15.0% | 15.0%≦ |
| Comparative examples | T1 | 12* | 6000 | 220 | 1.72 | 5.14 | 8.35 | 81.32 | 3.47 |
| | T2 | 12* | 6000 | 220 | 0.00 | 0.00 | 5.89 | 85.56 | 8.55 |
| | T3 | 12* | 6000 | 220 | 0.00 | 0.00 | 4.95 | 92.96 | 2.09 |
| | T4 | 12* | 6000 | 220 | 0.00 | 0.00 | 7.18 | 90.40 | 2.42 |
| Inventive examples | T5 | 25 | 4500 | 220 | 0.00 | 0.00 | 0.56 | 75.85 | 23.59 |
| | T6 | 30 | 4000 | 220 | 0.00 | 0.00 | 1.55 | 67.26 | 31.19 |
| | T7 | 30 | 4000 | 220 | 0.00 | 0.00 | 4.22 | 78.98 | 16.80 |
| | T8 | 30 | 4000 | 220 | 0.00 | 0.00 | 0.27 | 64.12 | 35.61 |
| Note: An asterisk * designates deviation from the range prescribed in the present invention. | | | | | | | | | |

Figure 4 shows the weighted average value of the conversion efficiency when used as solar cells in embodiments. As shown in Fig. 4, compared to the weighted average value of the conversion efficiency falling below 14.8 % for the comparative examples T1, T3 and T4, the weighted average value of the conversion efficiency for the inventive examples T5 - T8 of the present invention in all cases exceeded 14.8 %.

Moreover, as shown in Table 1, in the comparative examples T1 - T4, the percentage of the substrates with the conversion efficiency of 15.0 % or more as solar cells, fell below 9 %. On the other hand, in the examples of the present invention T5 - T8, the percentage of substrates with the conversion efficiency of 15.0 % or more as solar cells is 16 % or more.

As stated above, we have been able to establish that by means of the casting method of the present invention, it is possible to obtain in a secure manner solar cell substrates with high conversion efficiency and in addition also possible to obtain a high percentage of solar cell substrates with superior conversion efficiency Moreover, upon observing the cast ingot, the top part of the ingot of the comparative examples T1 - T4 was protruding like a cone, whereas in contrast, the top part of the ingot of the inventive examples of the present invention T5 - T8 was almost flat. From this, it was established that with the casting method for polycrystalline silicon of the present invention, it is possible to suppress the stirring of the molten silicon and to perform the electromagnetic casting with high current efficiency.

According to the casting method of the present invention, it is possible to lower the current value of the alternating current as a result of casting the polycrystalline silicon within a high frequency range at 25 - 35 kHz as the frequency of the alternating current applied on the induction coil whereby it is possible to maintain the surface temperature at high temperature at the time of solidifying the molten silicon and producing the ingot, by means of the skin effect caused by the high frequency and furthermore possible to delay the initiation of solidification from the ingot surface. As a result, it is possible to relatively suppress the growth of the chill layer.

Moreover, by lowering the current value of the alternating current applied on the induction coil, reducing the electromagnetic stirring force acting on the molten silicon and becoming possible to suppress the stirring of the molten silicon, thereby, it is possible to stimulate the growth of crystals with a large diameter in the inner part of the ingot. In addition, as it is possible to prevent the occurrence of melt drip by suppressing the stirring of the molten silicon, it is possible to suppress the deterioration of semiconductor properties at the ingot surface and in addition also possible to stabilize the configuration of the molten silicon whereby it becomes possible to perform the electromagnetic casting with high current efficiency.

In this way, according to the casting method for polycrystalline silicon of the present invention, as it is possible to suppress the deterioration of the semiconductor properties of the surface and the inner part of the ingot, it is possible to increase the conversion efficiency as a solar cell. As a result, the method is widely applicable as a casting method for polycrystalline silicon which offers the possibility of producing solar cells with superior quality and moreover at low production costs.

**Claims**

1.   A casting method for polycrystalline silicon in which: a bottomless cooling crucible with a part of a certain length in an axial direction being circumferentially and plurally sectioned is provided inside an induction coil; a silicon melt is produced within said cooling crucible by means of electromagnetically induced heating by said induction coil; and said silicon melt is withdrawn in a downward direction while being solidified, the method being **characterized in that** an alternating electric current with a frequency of 25 - 35 kHz is applied on said induction coil.

2.   The casting method for polycrystalline silicon according to claim 1, **characterized in that** a cross-section shape of a cast silicon ingot is a square of 300 - 450 mm in side length.

3.   The casting method for polycrystalline silicon according to claim 1 or claim 2, **characterized in that** said cast polycrystalline silicon is used for solar cell substrates.

FIG.1

EP 1 947 221 A2

FIG.2

11

FIG.3

FIG.4

## REFERENCES CITED IN THE DESCRIPTION

**Patent documents cited in the description**

*   JP S63192543 A